# EUROPÄISCHE PATENTSCHRIFT

(11) **EP 1 618 596 B1**
(45) Veröffentlichungstag und Bekanntmachung des Hinweises auf die Patenterteilung: **17.09.2008**
(21) Anmeldenummer: 04726945.1
(22) Anmeldetag: 13.04.2004
(51) Int. Cl.: H01L 21/00, F26B 15/04

(54) **VORRICHTUNG UND VERFAHREN ZUR WÄRMEBEHANDLUNG**
DEVICE AND METHOD FOR THERMAL TREATMENT
DISPOSITIF ET PROCEDE DE TRAITEMENT THERMIQUE

(30) Priorität: 17.04.2003 US 463481 P
(43) Veröffentlichungstag der Anmeldung: 25.01.2006
(73) Patentinhaber: Singulus Technologies AG, 63796 Kahl am Main (DE)
(72) Erfinder: EISENHAMMER, Thomas, CH-9478 Azmoos (CH); MATT, Thomas, A-6811 Göfis (AT); STRITTMATTER, Gebhard, 78462 Konstanz (DE); ZAPF, Klaus, 74336 Brackenheim (DE)
(74) Vertreter: Vossius & Partner
(86) Internationale Anmeldenummer: PCT/CH2004/000223
(87) Internationale Veröffentlichungsnummer: WO 2004/093161

(56) Entgegenhaltungen:
- EP-A- 0 399 616
- DE-C- 19 904 045

## Beschreibung

### Technisches Gebiet

Die Erfindung betrifft eine Vorrichtung und ein Verfahren zum Wärmebehandeln von Substraten, insbesondere von mit Flüssigkeiten oberflächenbeschichteten Kunstoffsubstraten für die Herstellung von Speicherscheiben, gemäss Oberbegriff von Anspruch 1. Ferner beschreibt die Erfindung ein Verfahren zum Betrieb einer solchen Vorrichtung.

### Hintergrund der Erfindung

Bei der Herstellung von Speicherscheiben, z. B. CD oder DVD, werden auf die Substrate bei bestimmten Fertigungsschritten Klebstoffe, Farben oder andere Schichten aufgetragen, die trocken sein müssen, bevor der nächste Fertigungsschritt stattfinden kann. Der Auftrag kann beispielsweise durch Bedrucken, spin coaten oder andere Weise geschehen. Die Farb-und Klebstoffe enthalten häufig Lösemittel oder Alkohole.

Ferner ist es bekannt, dass Polycarbonate, die häufig als Kunstoff für die Substrate eingesetzt werden, typischerweise ca. 0.3 Gewichtsprozent Wasser enthalten bzw. aufnehmen können. Dies ist bei vielen Vakuumbeschichtungsprozessen ein Nachteil, da unter Vakuum dieses Wasser ausgast, so die Vakuumbedingungen und die Schichtqualität (z. B. bei magnetooptischen Speicherscheiben) vermindert und daher in Konsequenz meist längere Abpumpzeiten erfordert.

Um die Prozesszeiten zu verkürzen bzw. die genannten Nachteile auszugleichen, werden die Substrate daher in einem Ofen unter kontrollierten Bedingungen getrocknet. Auch kann dabei ein Sinterungs- oder chemischer oder physikalischer Umwandlungsprozess durch die Wärmebehandlung bewerkstelligt werden (z. B. Änderung des Brechungsindexes einer aufgetragenen Schicht).

Üblicherweise unter Atmposphärenbedingungen werden die Substrate für Speicherscheiben in typischerweise 5 - 20 Minuten bei 60-120° C wärmebehandelt, z. B. getrocknet. Je nach Durchsatz des Herstellungsprozesses kann es erforderlich sein, eine grössere Anzahl von Substraten in einer solchen Anlage zwischenzulagern, die Kapazität variiert bei Trocknungsöfen für Speicherscheiben typischerweise zwischen 50-1200 Substraten.

Generelle Zielsetzungen für einen solche Wärmebehandlungsvorrichtung, im folgenden oft verkürzt, aber nicht einschränkend als Ofen bezeichnet, sind gute Be- und Entlademöglichkeiten, Kontrolle der Trocknungsbedingungen, Kompaktheit des Aufbaus und geringer Energiebedarf.

### Bekannter Stand der Technik

Bekannte Ausführungsformen für Trocknungsvorrichtungen dieser Gattung: Die zu trocknenden Substrate werden in einem beheizbaren Tunnel durch Strahlung oder im Gasstrom getrocknet. Gehalten werden die Substrate dabei von Aufnahmen, die an Schraubenspindeln befestigt sind, so dass durch deren Drehung die Substrate befördert werden. Die Ausführung ist liegend oder stehend möglich. Bei längeren Trocknungszeiten und/oder hohen Stückzahlen von Substraten werden diese Schraubspindeln sehr lange, was auch die Be- und Entladevorrichtungen räumlich trennt. Durch die Halterung am Aussenrand der Substrate kann, vor allem bei mit spin-coating beschichteten Substraten, die Halterung verschmutzt werden.

Alternativ zu Spindeln können die zu trocknenden Substrate in Körben oder Halterungen gesammelt oder auf Spindeln angeordnet werden und dann chargenweise getrocknet werden. Die Anordnung im Ofen kann dabei auf Drehtellern oder linear (Tunnelprinzip) erfolgen.

Eine bekannte Ausführungsform zeigt die DE 199 04 045 Cl. Dort werden auf einer Spindel angeordnete Substrate in einem rotierenden Ofen im Luftstrom getrocknet. Die Heizvorrichtung ist im Mittenbereich des Ofens angebracht.

Nachteil dieser Vorrichtung ist, dass der Durchmesser des Ofens bei Vergrösserung der Kapazität stark zunimmt. Ferner zirkuliert der Luftstrom im Innenraum an allen Disks vorbei, was der Homogenität und der Steuerbarkeit des Trocknungsvorgangs wenig Spielraum lässt.

### Aufgabe der Erfindung

Der Erfindung liegt die Aufgabe zu Grunde, eine Vorrichtung und ein Verfahren zur Trocknung von Substraten, insbesondere Speicherscheiben zu zeigen, bei welchem die Nachteile des Standes der Technik vermieden werden. Insbesondere soll die Erfindung eine höhere Zahl an Substraten aufnehmen können bei gleichzeitig kompakten Abmessungen sowie individuelle Zonen zur Temperaturbehandlung ermöglichen. Der Trocknungsvorgang soll homogen erfolgen und in weitem Bereich steuerbar sein. Eine weitere Aufgabe der Erfindung liegt darin, bei vereinfachter mechanischer Konstruktion Energieeinsparungen im Vergleich zum Stand der Technik zu ermöglichen.

Diese Aufgaben werden durch die vorliegende Erfindung gelöst. Im Folgenden wird die Erfindung anhand von einzelnen Ausführungs- bzw. vergleichenden Beispielen sowie der Figur näher erläutert.

### Lösung gemäss der Erfindung

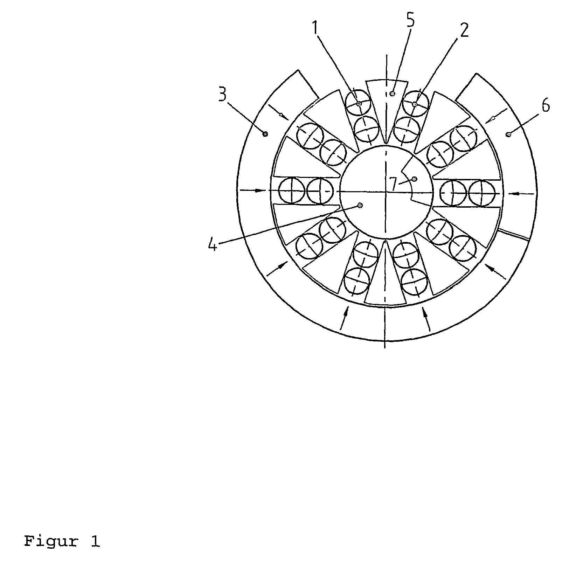

Figur 1 zeigt eine erfindungsgemässe Trocknungsvorrichtung. Die in Aufsicht im wesentlichen kreisförmige Anordnung besteht aus einem äusseren Mantelbereich 3 und 6, einem Kernbereich 4 und einem dazwischenliegenden eigentlichen Wärmebehandlungsbereich, der speichenförmig angeordnete Wärmebehandlungszonen mit dazwischenliegenden Sektoren 5 aufweist. Je nach Auslegung können 6 - 20 Wärmebehandlungszonen realisiert werden. Der Mantelbereich 3, 6 weist im Be- und Entladebereich 1 und 2 eine Aussparung auf.

Die Trocknungsvorrichtung enthält einen Drehteller (nicht gezeigt) mit Aufnahmen für Substrathalter, (hier) in Spindeln chargierte Substrate. Diese Spindeln bestehen beispielsweise aus einem zentralen Dorn, über den die mit einem Mittenloch versehenen Substrate aufgefädelt werden, jeweils durch ein Distanzstück getrennt. Ohne den Erfindungsgedanken zu verändern, können andere Chargiermöglichkeiten angewendet werden. Durch die Anordnung der Spindeln radial hintereinander wird erreicht, dass sie von oben betrachtet konzentrisch um den Drehtellermittelpunkt, in den Speichen hintereinander angeordnet sind.

Vorteilhafterweise werden mindestens 2, je nach Substratgrösse auch 3 oder mehr Spindeln hintereinander angeordnet, was zu entsprechenden konzentrischen Anordnungen führt.

In einer Ausführung der Erfindung sind Heiz- und Gasfördervorrichtungen sowie bei Bedarf Partikelfilter im Mantelbereich 3 angeordnet und erzeugen einen temperierten Gas- bzw.

Luftstrom radial von aussen nach innen zum Kernbereich 7, wo der Luftstrom z. B. umgelenkt und über eine (nicht gezeigte) an der Oberseite des Ofens angeordnete Leitvorrichtung zurück in den Mantelbereich 3 gelenkt wird. Dies erlaubt, zu Wartungszwecken Heiz- und z. B. Gebläsevorrichtungen von aussen zugänglich zu machen, und im Innenbereich 7 auf bewegte Teile zu verzichten. Zudem kann die Leiteinrichtung so ausgelegt werden, dass über einen Feuchtigkeits- und Temperaturmesser der Zustand des Gases überwacht wird. Je nach Anwendungsfall kann dann ein Teil des Gas- resp. Luftstroms als Fortluft abgeführt werden und durch Frischluft ersetzt werden. Eine Wärmetauscher zur Abkühlung der Fortluft bzw. Vorwärmung der Frischluft erlaubt den Energiebedarf weiter zu senken.

Ferner ist es möglich, den Luftstrom umgekehrt von innen nach aussen zu führen, wobei die Heizvorrichtungen bevorzugt dann zentral im Mittelpunkt angeordnet werden. Die weiter geschilderten Vorteile werden bei beiden Anordnungen erzielt.

Die Zwischenwände 5 erlauben, den Luftstrom zu lenken, insbesondere einen gleichmässigen Luftstrom zu erzeugen, was der Gleichmässigkeit der Wärmebehandlung der Substrate zugute kommt. Die radiale Ausrichtung des Luftstroms erlaubt es dabei in Verbindung mit den Zwischenwänden, in verschiedenen Bereichen des Mantelbereichs unterschiedliche Temperaturbereiche zu realisieren, indem den (ortsfesten) Einblasbereichen des Mantelbereichs 3 Luftströme mit unterschiedlichen Temperaturbereichen zugeordnet werden.

### Verfahrensbeispiel gemäss der Erfindung

Auf Spindeln chargierte Substrate werden bei 1 in die Wärmebehandlungsvorrichtung eingeführt und mit entsprechenden Halterungen fixiert. Der schachtförmige Abschnitt, die Wärmebehandlungszone nimmt hier, radial betrachtet 2 Spindeln hintereinander auf. Jede Wärmebehandlungszone ist von 2 Wandbereichen flankiert, die zu den benachbarten Zwischensektoren 5 gehören. Wärmebehandlungszone und Zwischensektoren sind drehbar auf einem Drehteller angeordnet. Vorzugsweise wird dieser Drehteller gesteuert angetrieben, z. B. langsam kontinuierlich oder in Intervallen, wobei der Drehteller bei jeder Intervallbewegung um einen Drehwinkel so weiterbewegt wird, dass die Position jeder Wärmebehandlungszone um eins weitergeführt wird. Für die Zwecke des Beispiels sei die Bewegung im Gegenuhrzeigersinn betrachtet. Die Spindeln werden im folgenden der Wärmebehandlung unterzogen und bewegen sich bis zur Ausschleusposition 2 fort.

Dabei kann, wie oben erwähnt, durch unterschiedlich erwärmte Zuluft bzw. durch Variation der Luftmenge in den verschiedenen Sektoren des Mantelbereichs 3 eine abgestufte Temperaturbehandlung erreicht werden. Dadurch kann der Verlauf der Substraterwärmung gesteuert werden und z. B. unerwünschte Temperatursprünge werden vermieden, was z. B. Substratverbiegungen vermeiden hilft.

Der in Figur 1 mit 6 bezeichnete Bereich ist beispielhaft als Kühlbereich ausgelegt. Die Einblasbereiche dort führen kühle Luft an die Substrate, so dass vor der Weiterbearbeitung eine evtl. notwendige Handhabungstemperatur gewährleistet werden kann. Vorteilhafterweise kann die von den Substraten erwärmte Kühlluft im Bereich 3 den Wärmeerzeugern zugeführt werden und so den Energiebedarf der Gesamtanlage senken helfen. Es ist aber auch eine Abführung der Kühlluft über einen separaten Abluftschacht 7 möglich.

Durch die Ausgestaltung der Zwischensektoren 5 kann auf eine zusätzliche Abdeckung des Ein- und Ausschleussbereichs verzichtet werden. Die dem Kreisbogen angepassten, radial aussen liegenden Wände der Zwischensektoren 5 decken, wie in Figur 1 leicht ersichtlich, Innenbereiche des Ofens mit ab und vermindern so die Energieverluste. Zudem kann auf mechanisch bewegte Teile, wie Türen, Schleusen oder schwenkbare Abschirmbleche verzichtet werden.

Je nach Aufgabenbereich und Taktrate können Ein- und Ausschleussbereich auch funktionell vereinigt werden. Wenn die Taktrate es zulässt kann an nur einer Station ent- und anschliessend wieder beladen werden. Das hat zudem den Vorteil, dass nur ein Handlingsystem vorhanden sein muss statt deren zwei.

### Weitere Vorteile der Erfindung

Durch Vorsehen von Drehantrieben an den Spindeln ist es möglich, diese während der Wärmebehandlung zu rotieren, was die Erwärmung gleichmässiger werden lässt. Die Drehantriebe können elektrisch individuell oder über Zahnräder, die an einem ortsfest angebrachten Zahnkranz abrollen, realisiert werden.

Durch Anbringen von Sensoren in den Wärmebehandlungszonen kann eine individuelle Kontrolle des Temperaturverlaufs pro Wärmebehandlungszone realisiert werden. Eine entsprechende Auswertungseinheit, z. B. ein PC, erlaubt auf diese Weise, korrigierend einzugreifen oder einen vorgesehenen Temperaturverlauf einzustellen. Diese Auswerteinheit kann parallel dazu die Regelung der Feuchtigkeits- und Temperaturverhältnisse von Zuluft und Fortluft überwachen.

## Patentansprüche

1. Vorrichtung zur Wärmebehandlung von Substraten, mit einem ringförmigen Wärmebehandlungsbereich mit einem Drehteller zur Aufnahme von Substrathaltern, einem Kernbereich (4) um die Zentralachse des Drehtellers, einem Mantelbereich (3, 6) um den Wärmebehandlungsbereich, einer Be- und Entladezone (1, 2) für die Substrathalter, mindestens einer Wärmequelle zur Erwärmung eines Gasstroms und Gasstromführungsvorrichtungen, **dadurch gekennzeichnet, dass** die Substrathalter mindestens zu zweien hintereinander in Wärmebehandlungszonen angeordnet sind, die wiederum in Speichenform radial um den Drehtellermittelpunkt angeordnet sind.

2. Vorrichtung nach Anspruch 1, **dadurch gekennzeichnet, dass** zwischen den Wärmebehandlungszonen Zwischensektoren (5) angeordnet sind, mit Wandungen, die die Wärmebehandlungszonen seitlich flankierend, speichenparallel begrenzen.

3. Vorrichtung nach Anspruch 1 bis 2, **dadurch gekennzeichnet, dass** der Drehteller um seine Zentralachse rotierend motorisch antreibbar ist.

4. Vorrichtung nach Anspruch 1-3, **dadurch gekennzeichnet, dass** die Wärmequelle im Mantelbereich (3, 6) angeordnet ist und die Gasstromführungsvorrichtungen den Gasstrom vom Mantelbereich radial durch die Wärmebehandlungszonen zur Zentralachse lenken.

5. Vorrichtung nach Anspruch 1-4, **dadurch gekennzeichnet, dass** der Gasstrom aus mindestens einem Abschnitt des Mantelbereichs (6) sich in Bezug auf Temperatur und/oder Gasmenge vom Gasstrom aus dem restlichen Mantelbereich (3) unterscheidet.

6. Vorrichtung nach Anspruch 5, **dadurch gekennzeichnet, dass** der aus dem Mantelbereich (6) stammende Gasstrom kühler als der aus dem Mantelbereich (3) stammende Gasstrom ist und zur Kühlung der Substrate dient.

7. Verfahren zum Wärmebehandeln von Substraten in einer Vorrichtung gemäss Ansprüchen 1-6, **dadurch gekennzeichnet, dass** der Drehteller während des Betriebs diskontinuierlich in gesteuerten Intervallen sich jeweils so weit dreht, bis die Wärmebehandlungszonen wieder deckungsgleich, aber um eine Position weiterverschoben vorliegen.

8. Verfahren zum Wärmebehandeln von Substraten nach Anspruch 7 in einer Vorrichtung nach Anspruch 1-6, **dadurch gekennzeichnet, dass** die Gasstromführungsvorrichtungen so ausgelegt werden, dass der Gasstrom gleichmässig die Wärmebehandlungszonen durchströmt.

9. Verfahren zum Wärmebehandeln von Substraten nach Anspruch 7 und 8 in einer Vorrichtung nach Anspruch 1-6, **dadurch gekennzeichnet, dass** der zur Kühlung verwendete Gasstrom anschliessend als Zuluft für die Wärmequelle des Gasstroms dient.

## Claims

1. An apparatus for the heat treatment of substrates, incorporating an annular heat-treatment section that includes a rotary table for receiving substrate holders, a core section (4) around the central axis of the rotary table, a jacket section (3, 6) surrounding the heat-treatment area, loading and unloading areas (1, 2) for the substrate holders, at least one heat source for heating a gas flow, and gas flow conduits, **characterized in that** at least two substrate holders are positioned one behind the other in heat-treatment zones which in turn are positioned in a radial spoke pattern around the center of the rotating table.

2. The apparatus of claim 1, **characterized in that** interstitial sectors (5) are arranged between the heat-treatment zones, said interstitial sectors (5) having walls that laterally partition the heat-treatment zones from one another in parallel-spoke fashion.

3. The apparatus of claims 1 to 2, **characterized in that** the rotary table can be motor-driven around its central axis of rotation.

4. The apparatus of claims 1 to 3, **characterized in that** the heat source is situated in the jacket section (3, 6) and that the gas flow conduits direct the gas flow from the jacket section radially through the heat-treatment zones and to said central axis.

5. The apparatus of claims 1 to 4, **characterized in that** in terms of temperature and/or volume, the gas flow from at least one part of the jacket section (6) differs from the gas flow from the remaining jacket section (3).

6. The apparatus of claim 5, **characterized in that** the gas flow coming from the jacket section (6) is cooler than the gas flow coming from the jacket section (3) and serves to cool the substrates.

7. A method for heat-treating substrates in an apparatus according to claims 1 to 6, **characterized in that** during operation the rotary table rotates in discontinuous fashion at controlled intervals, in each case far enough to realign the heat-treatment zones but advanced by one to the next position.

8. The method for heat-treating substrates according to claim 7 in an apparatus according to claims 1 to 6, **characterized in that** the gas flow conduits are so configured that the gas flow flows uniformly through the heat-treatment zones.

9. The method for heat-treating substrates according to claims 7 and 8 in an apparatus according to claims 1 to 6, **characterized in that** the gas flow used for cooling purposes subsequently serves as an air supply for the heat source of the gas flow.

## Revendications

1. Dispositif de traitement thermique de substrats ayant une zone annulaire de traitement thermique avec une plaque de rotation pour recevoir des supports de substrat, une zone de coeur (4) autour de l'axe centrale de la plaque de rotation, une zone de manteau (3, 6) entourant la zone de traitement thermique, des zones de charge et de décharge (1, 2) pour les supports de substrat, au moins une source de chaleur pour chauffer un courant de gaz, et des dispositifs de conduit de courant de gaz, **caractérisé en ce que** les supports de substrat sont positionnés au moins à deux l'un derrière l'autre dans des zones de traitement thermique qui, elles, sont positionnées radialement en forme de rayons autour du centre de la plaque de rotation.

2. Dispositif selon la revendication 1, **caractérisé en ce qu'**il y a des secteurs intermédiaires (5) disposées entre les zones de traitement thermique, lesdites zones intermédiaires ayant des parois encadrant les zones de traitement thermique latéralement et parallèlement au plan des rayons.

3. Dispositif selon les revendications 1 à 2, **caractérisé en ce que** la plaque de rotation peut être propulsée par un moteur pour tourner sur son axe central.

4. Dispositif selon les revendications 1 à 3, **caractérisé en ce que** la source de chaleur est disposée dans la zone de manteau (3, 6) et que les dispositifs de conduit de courant de gaz amènent le courant de gaz radialement de la zone de manteau par les zones de traitement thermique vers l'axe central.

5. Dispositif selon les revendications 1 à 4, **caractérisé en ce que** le courant de gaz provenant d'au moins une partie de la zone de manteau (6) diffère, en termes de température et/ou de quantité du gaz, du courant de gaz provenant de la zone de manteau restante (3).

6. Dispositif selon la revendication 5, **caractérisé en ce que** le courant de gaz provenant de la zone de manteau (6) est plus froid que le courant de gaz provenant de la zone de manteau (3) et sert à refroidir les substrats.

7. Procédé de traitement thermique de substrats dans un dispositif selon les revendications 1 à 6, **caractérisé en ce que** durant l'opération la plaque de rotation tourne de manière discontinue en intervalles contrôlés, dans chaque intervalle jusqu'à ce que les zones de traitement thermique soient de nouveau en ligne, mais soient déplacées d'une position.

8. Procédé de traitement thermique de substrats selon la revendication 7 dans un dispositif selon les revendications 1 à 6, **caractérisé en ce que** les dispositifs de conduit de courant de gaz sont configurés tels que le courant de gaz coule homogènement par les zones de traitement thermique.

9. Procédé de traitement thermique de substrats selon les revendication 7 et 8 dans un dispositif selon les revendications 1 à 6, **caractérisé en ce que** le courant de gaz utilisé pour le refroidissement est ensuite utilisé comme air amendé pour la source de chaleur du courant de gaz.
